# EUROPEAN PATENT APPLICATION

(11) **EP 4 693 384 A1**
(43) Date of publication of application: **11.02.2026**
(21) Application number: 23930455.3
(22) Date of filing: 29.03.2023
(51) Int. Cl.: H01L 21/677

(54) **SUBSTRATE PROCESSING DEVICE**

(71) Applicant: Daikin Finetech, Ltd., Yamatokoriyama-shi, Nara 639-1031 (JP)
(72) Inventor: USHIDA, Satoshi, Yamatokoriyama-shi, Nara 639-1031 (JP); YAMAMOTO, Hitoshi, Yamatokoriyama-shi, Nara 639-1031 (JP); FUJII, Kana, Yamatokoriyama-shi, Nara 639-1031 (JP)
(74) Representative: Boult Wade Tennant LLP
(86) International application number: PCT/JP2023/012909
(87) International publication number: WO 2024/201817

(57) **Abstract**

A substrate processing apparatus A1 includes a substrate processing unit U1 having a first chamber 1A that performs a first process including moistening a substrate W, and a second chamber 1B that performs a second process on the substrate W after the first process, a first transport system 3 that brings the substrate W into the substrate processing unit U1, and brings the substrate W out of the substrate processing unit U1, and a second transport system 4A that brings the substrate W out of the first chamber 1A, and brings the substrate W into the second chamber 1B. The configuration enables improvement in processing capacity of the substrate processing apparatus and more appropriate transport of the substrate.

## Description

### TECHNICAL FIELD

The present invention relates to a substrate processing device/apparatus.

### BACKGROUND ART

Various substrate processing apparatuses for performing required processing on substrates such as semiconductor wafers have been proposed. Patent document 1 discloses an example of conventional substrate processing apparatus. The substrate processing apparatus disclosed in the document includes a plurality of chambers, each configured to perform a predetermined processing on substrates, a buffer unit, a first transport robot, and a second transport robot. The first transport robot brings substrates provided from outside onto the buffer unit. The second transport robot carries the substrates placed on the buffer unit into the chambers, carries the substrates between the chambers, and carries out the substrates from the chambers to bring them to the buffer unit.

### PRIOR ART DOCUMENT

### Patent Document

Patent Document 1: JP-A-2019-197799

### SUMMARY OF THE INVENTION

### Problem to be Solved by the Invention

When the above-noted carrying in and out by the second robot are frequently performed, the processing capacity of the substrate processing apparatus may be degraded. In addition, in the case of carrying the substrates between the chambers, the second transport robot may have to handle wet substrates. On the other hand, it may be preferable that the substrates having undergone a series of processing in the chambers should be carried out to the buffer unit in a dry state. When the second transport robot is configured to handle both wet substrates and dry substrates, it may unduly moisten substrates that should be kept dry.

The present invention has been proposed in view of the above circumstances, and an objective of the invention is to provide a substrate processing apparatus which is capable of improving the processing capacity and performing more appropriate transporting of the substrates.

### Means to Solve the Problem

In an aspect, the present invention provides a substrate processing apparatus including a substrate processing unit having a first chamber that performs a first process including moistening a substrate, and a second chamber that performs a second process on the substrate after the first process, a first transport system that brings the substrate into the substrate processing unit, and brings the substrate out of the substrate processing unit, and a second transport system that brings the substrate out of the first chamber, and brings the substrate into the second chamber.

In a preferred embodiment of the present invention, the first process employs a chemical solution containing a chemical agent as a processing liquid, and the second process includes water-washing the substrate.

In a preferred embodiment of the present invention, the first chamber and the second chamber are aligned in a first direction, and the first transport system and the second transport system are opposed to each other across the substrate processing unit in a second direction perpendicular to the first direction.

In a preferred embodiment of the present invention, the substrate processing apparatus includes the first transport system, two of the substrate processing units opposed to each other across the first transport system in the second direction, and two of the second transport systems opposed to each other across the two substrate processing units in the second direction.

In a preferred embodiment of the present invention, the second transport system includes a holder that retains the substrate. The holder is configured to move via an intermediate standby position outside of the first chamber and the second chamber, where the intermediate standby position overlaps with the first chamber and the second chamber as viewed in the first direction, and also overlaps with the first chamber and the second chamber as viewed in the second direction.

In a preferred embodiment of the present invention, the first chamber includes a first cover, and the second chamber includes a second cover. A portion of each of the first cover and the second cover that is opposed to the second transport system has an arcuate shape as viewed in a third direction perpendicular to the first direction and the second direction.

In a preferred embodiment of the present invention, the substrate processing unit further includes a chemical tank for storing the chemical solution for processing the substrate. The chemical tank includes a first outlet and a second outlet for discharging the chemical solution, and a bottom face located at a lower position in a vertical direction. The first outlet is located at an upper position from the second outlet in the vertical direction, and the bottom face is inclined with respect to a direction in which the first outlet and the second outlet are spaced apart from each other in a manner such that a portion of the bottom face on a side of the second outlet is lower in the vertical direction.

In a preferred embodiment of the present invention, the substrate processing unit further includes a piping unit through which the chemical solution for processing the substrate flows. The piping unit is configured to be removed out from the substrate processing unit with the first chamber and the second chamber remaining fixed.

### Advantages of the Invention

With the mentioned configuration according to the present invention, improvement in processing capacity of the substrate processing apparatus and more appropriate transport of the substrate can both be attained.

Other features and advantages of the present invention will become more apparent, through detailed description given hereunder with reference to the accompanying drawings.

### BRIEF DESCRIPTION OF THE DRAWINGS

FIG. 1 is a perspective view showing a substrate processing apparatus according to a first embodiment of the present invention.
FIG. 2 is a plan view showing the substrate processing apparatus according to the first embodiment of the present invention.
FIG. 3 is a cross-sectional view taken along a line III-III in FIG. 2.
FIG. 4 is a cross-sectional view taken along a line IV-IV in FIG. 2.
FIG. 5 is a cross-sectional view taken along a line V-V in FIG. 2.
FIG. 6 is a plan view showing a substrate transport route in the substrate processing apparatus according to the first embodiment of the present invention.
FIG. 7A is a plan view showing an example of a second transport system in the substrate processing apparatus according to the first embodiment of the present invention.
FIG. 7B is a plan view showing another example of a second transport system in the substrate processing apparatus according to the first embodiment of the present invention.
FIG. 8A is a partial plan view showing a variation of the substrate processing apparatus according to the first embodiment of the present invention.
FIG. 8B is a partial plan view showing another variation of the substrate processing apparatus according to the first embodiment of the present invention.
FIG. 8C is a partial plan view showing another variation of the substrate processing apparatus according to the first embodiment of the present invention.
FIG. 9 is a front view showing a substrate processing apparatus according to a second embodiment of the present invention.
FIG. 10A is a plan view showing a substrate processing apparatus according to a third embodiment of the present invention.
FIG. 10B is a cross-sectional view taken along a line X-X in FIG. 10A.
FIG. 11A is a front view showing an example of a chemical tank in the substrate processing apparatus according to the present invention.
FIG. 11B is a left-side view showing the example of the chemical tank in the substrate processing apparatus according to the present invention.
FIG. 11C is a right-side view showing the example of the chemical tank in the substrate processing apparatus according to the present invention.
FIG. 12 is a schematic diagram showing an example of a flow path of a chemical solution, realized by the chemical tank shown in FIG. 11.
FIG. 13 is a schematic diagram showing another example of the flow path of the chemical solution, realized by the chemical tank shown in FIG. 11.
FIG. 14A is a cross-sectional view showing a substrate processing apparatus according to a fourth embodiment of the present invention.
FIG. 14B is a cross-sectional view showing the substrate processing apparatus according to the fourth embodiment of the present invention.

### MODE FOR CARRYING OUT THE INVENTION

Preferred embodiments of the present invention will be described in detail below with reference to the drawings.

The terms "first", "second", "third", and the like used in the present disclosure are merely for distinction of the elements from one another, and not intended to indicate an order or a rank of the elements.

### <First Embodiment>

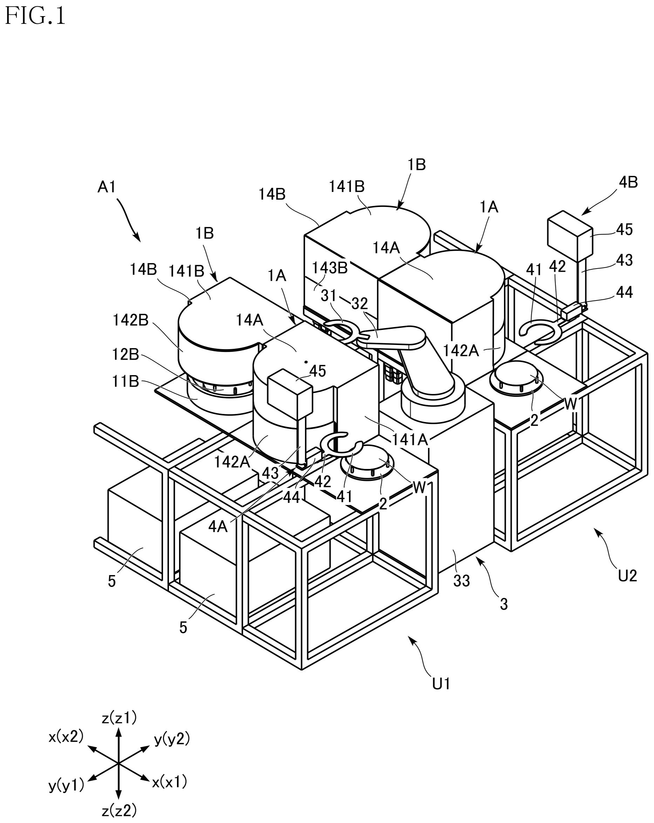

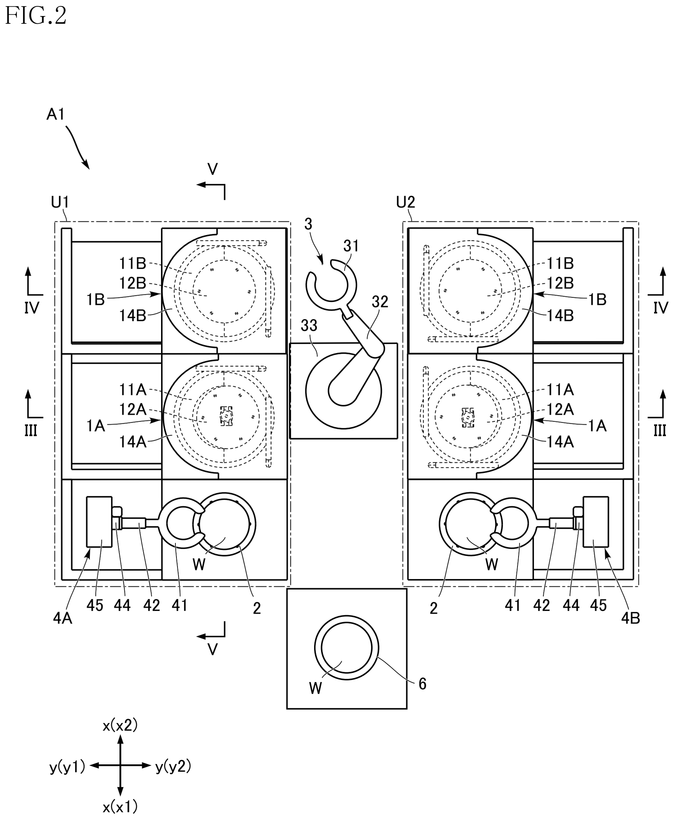

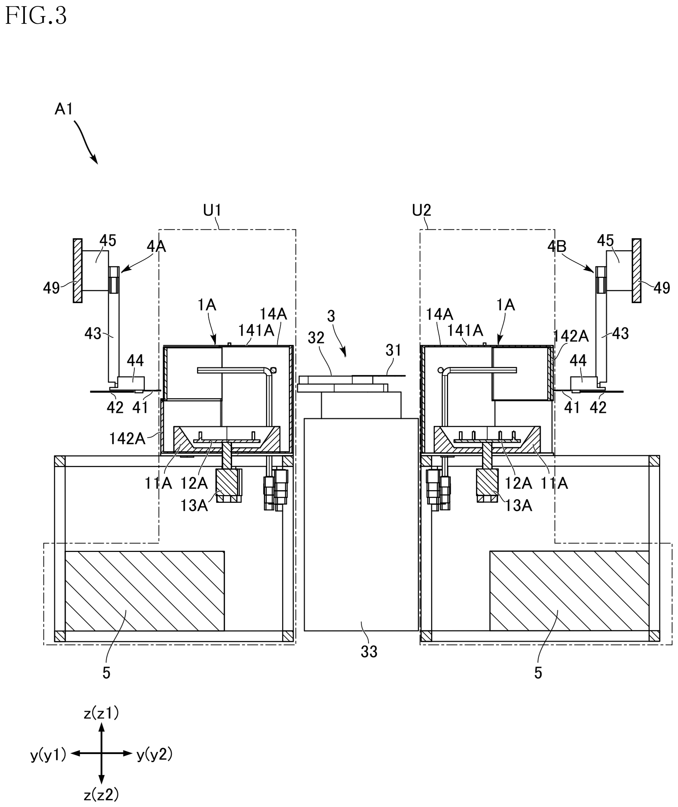

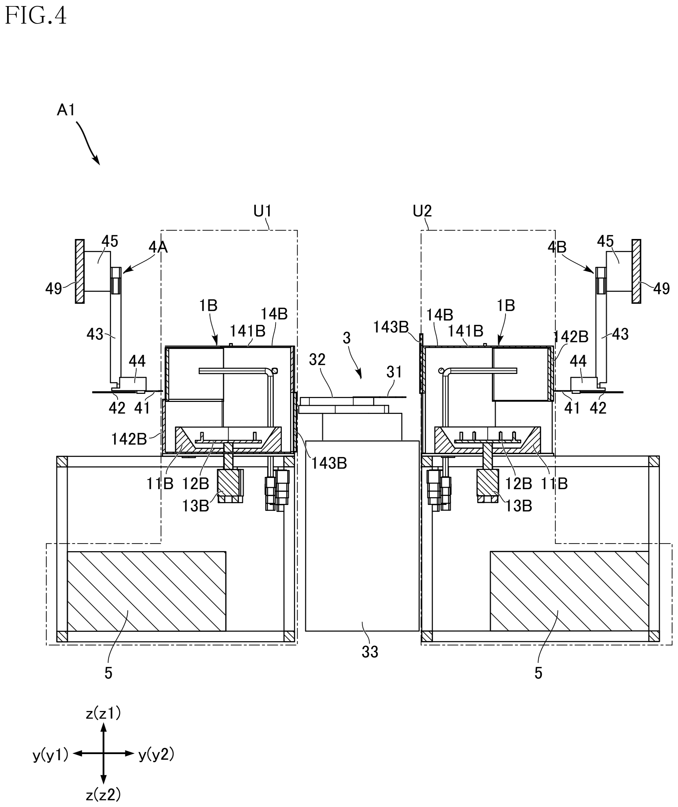

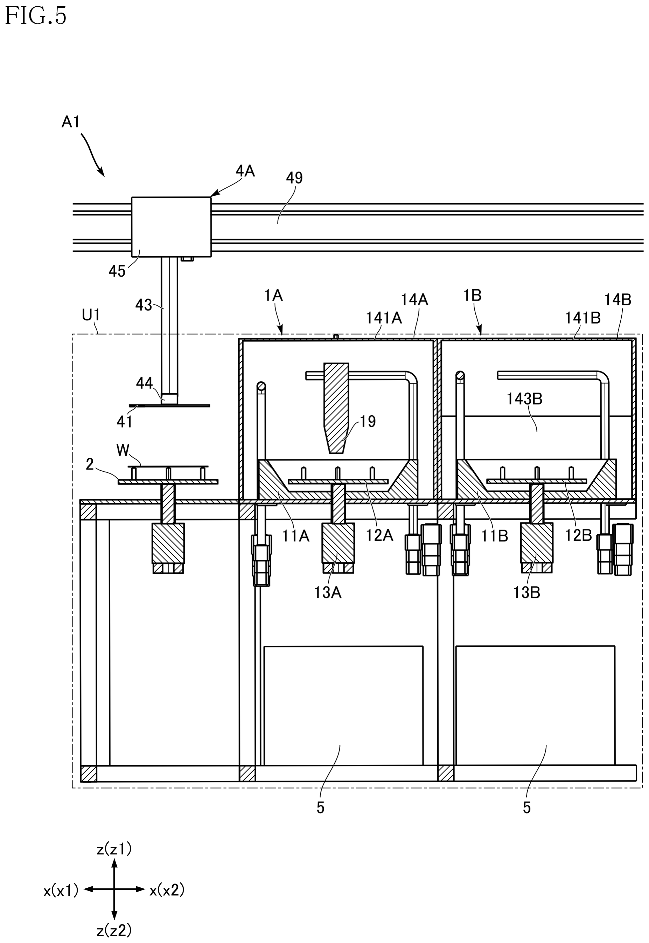

FIG. 1 to FIG. 7B illustrate a substrate processing apparatus according to a first embodiment of the present invention. The substrate processing apparatus A1 of this embodiment includes two substrate processing units U1 and U2, a first transport system 3, two second transport systems 4A and 4B, and a load/unload stage 6. The substrate processing apparatus A1 is configured to perform a predetermined processing on a substrate(s) W to be provided on the load/unload stage 6. In the drawings, the x direction may correspond to a first direction for the present invention, the y direction may correspond to a second direction, and the z direction may correspond to a third direction. In the illustrated embodiment, the z direction coincides with the vertical direction.

The substrate W is not limitative in structures, and may be a semiconductor wafer, for example. When the substrate W is a semiconductor wafer, the substrate W may have, for example, a circular shape.

The two substrate processing units U1 and U2 are each configured to perform a predetermined processing on the substrate W. The two substrate processing units U1 and U2 may have the same configuration or different configurations. In this embodiment, the two substrate processing units U1 and U2 have the same configuration. In addition, the number of the substrate processing units to be used for the substrate processing apparatus of the present invention is not limitative, and use may be made of a single unit or more than two units. In this embodiment, the two substrate processing units U1 and U2 are spaced from each other in the y direction so as to be on the mutually opposite sides of the intervening first transport system 3 in the y direction.

In describing the substrate processing units U1 and U2 of this embodiment, use may be made of expressions such as "outer side in the y direction" and "inner side in the y direction". For the substrate processing unit U1, the outer side in the y direction corresponds to the y1-side, and the inner side in the y direction corresponds to the y2-side. For the substrate processing unit U2, the outer side in the y direction corresponds to the y2-side, and the inner side in the y direction corresponds to the y1-side.

Each of the substrate processing units U1, U2 includes a first chamber 1A and a second chamber 1B. In this embodiment, each of the substrate processing units U1 and U2 also includes a preparation stage 2 and two piping units 5. The first chamber 1A and the second chamber 1B may have the same or similar configuration, or may have different configurations. When the first chamber 1A and the second chamber 1B have the same configuration, a higher degree of freedom can be enjoyed in designing a combination of the substrate processing units U1 and U2, and a wider variety of usage can be designed. In addition, when the first chamber 1A and the second chamber 1B, previously utilized for a certain purpose, are to be used for a different purpose, only a small number of parts may need to be modified . Further, the first chamber 1A and the second chamber 1B themselves may be unitized as appropriate. Then, when one of the first chambers 1A and the second chambers suffers a trouble such as leakage of a chemical solution, the chamber in trouble can be easily replaced with another one.

When a substrate W is brought to the substrate processing unit U1 or U2, the preparation stage 2 receives the substrate W. The function of the preparation stage 2 is not limitative. For example, the preparation stage 2 may be used to temporarily keep the substrate W thereon for time adjustment prior to the processing in the first chamber 1A or the second chamber 1B. The preparation stage 2 may also be configured to adjust the orientation or posture of the substrate W. Alternatively, the substrate processing units U1 and U2 may not be provided with a preparation stage 2, and the substrate W may be directly carried into the first chamber 1A.

The first chamber 1A performs a first process on the substrate W carried in by way of the preparation stage 2. The first chamber 1A may have various configurations, for example depending on the operations performed as the first process. The first process includes moistening the substrate W. The method to moisten the substrate W is not limitative. For example, the substrate W may be soaked in a processing liquid, or a processing liquid may be sprayed onto the substrate W. In the present embodiment, the first process includes a liftoff process to be performed on the substrate W. The first chamber 1A of this embodiment includes a first container 11A, a first stage 12A, a first drive mechanism 13A, a first cover 14A, and an ultrasonic horn 19.

The first container 11A is for processing the substrate W, and configured to store a processing liquid for processing the substrate W. The composition of the processing liquid is not limitative. For example, pure water, or a chemical solution containing a predetermined chemical agent(s) may be employed. When the liftoff process is performed, for example a chemical solution containing an organic solvent is employed. The examples of the organic solvent may be isopropyl alcohol (IPA), N-methyl-2-pyrrolidone (NMP), and the like.

The first stage 12A supports the substrate W, when the liftoff process is performed in the first container 11A. The first stage 12A may also serve as a base for receiving the substrate W carried into the first chamber 1A. Further, the first stage 12A may serve as a base supporting the substrate W, so that the substrate W can be carried out of the first chamber 1A, after the process in the first container 11A is finished.

The first drive mechanism 13A serves to drive the first stage 12A. The first drive mechanism 13A is, for example, used to rotate the substrate W in the processing liquid stored in the first container 11A, by rotating the first stage 12A about an axis extending in the z direction. The first drive mechanism 13A may also be configured to move the first stage 12A up and downward in the z direction.

The ultrasonic horn 19 applies an ultrasonic wave to the substrate W soaked in the processing liquid in the first container 11A, for example to remove a resist layer and a metal layer on the substrate. The structure of the ultrasonic horn 19 is not limitative. The first chamber 1A may be without the ultrasonic horn 19, and may include different mechanisms for performing the liftoff process or different processes.

The first cover 14A serves to shield the first container 11A from outside, when the substrate W is processed. In this embodiment, the first cover 14A accommodates the first container 11A and the first stage 12A, and also the ultrasonic horn 19. The structure of the first cover 14A is not limitative. In this embodiment, the first cover 14A includes a fixed portion 141A and a first shutter 142A.

The fixed portion 141A may constitute a main body of the first cover 14A, and is fixed to a suitable support framework, for example. The fixed portion 141A includes an opening for carrying-in and -out the substrate W. In the illustrated example, the fixed portion 141A is open toward the outer side in the y direction. In other words, the fixed portion 141A of the first chamber 1A of the substrate processing unit U1 is open toward the y1-side in the y direction, while the fixed portion 141A of the first chamber 1A of the substrate processing unit U2 is open toward the y2-side in the y direction.

The first shutter 142A serves to open and close the opening of the fixed portion 141A, and is movable relative to the fixed portion 141A. The way the first shutter 142A moves is not limitative. In the illustrated example, the first shutter 142A moves up and downward in the z direction. The mechanism for moving the first shutter 142A (not shown) is not limitative. For example, use may be made of an air cylinder or a motor.

The shape of the first cover 14A is not limitative. In the illustrated example, the first cover 14A protrudes to the outer side in the y direction as viewed in the z direction, and includes, for example, a semicircular portion. Accordingly, the first shutter 142A also has an arcuate shape as viewed in the z direction.

The second chamber 1B serves to perform a second process on the substrate W, which has undergone the first process in the first chamber 1A. The second chamber 1B may have various structures, for example depending on the operation to be performed as the second process. In this embodiment, the second process includes cleaning the substrate W that has undergone the liftoff process. The second chamber 1B of this embodiment includes a second container 11B, a second stage 12B, a second drive mechanism 13B, and a second cover 14B. The second chamber 1B may be configured to, for example, rotate the second stage 12B at a high speed, thereby centrifugally removing the processing liquid on the substrate W. Further, the second chamber 1B may be configured to dry the substrate W with dry gas such as air or nitrogen. Such configurations assure that the substrate W is prevented from being moistened, while being transported by the first transport system 3.

The second container 11B is for processing the substrate W, and configured to store the processing liquid for processing the substrate W. The composition of the processing liquid is not limitative and, for example, pure water, or a chemical solution containing a predetermined chemical agent may be employed. To clean the substrate W, for example pure water may be employed.

The second stage 12B supports the substrate W, when the cleaning is performed in the second container 11B. The second stage 12B may also serve as a base for receiving the substrate W carried into the second chamber 1B. Further, the second stage 12B may serve as a base supporting the substrate W, so that the substrate W can be carried out of the second chamber 1B after the process in the second container 11B is finished.

The second drive mechanism 13B serves to drive the second stage 12B. The second drive mechanism 13B is, for example, used to rotate the substrate W in the processing liquid stored in the second container 11B, by rotating the second stage 12B about an axis extending in the z direction. The second drive mechanism 13B may also be configured to move the second stage 12B up and downward in the z direction.

The second cover 14B serves to shield the second container 11B from outside when the substrate W is subjected to the process. In this embodiment, the second cover 14B accommodates the second container 11B and the second stage 12B. The structure of the second cover 14B is not limitative. In this embodiment, the second cover 14B includes a fixed portion 141B, a second shutter 142B, and a carry-out shutter 143B.

The fixed portion 141B may constitute a main body of the second cover 14B, and is fixed to a support framework. The fixed portion 141B includes an opening for carrying-in and - out the substrate W. In the illustrated example, the fixed portion 141B is open toward the inner side and the outer side in the y direction. In other words, the fixed portion 141B is open toward the y1-side and the y2-side in the y direction.

The second shutter 142B serves to open and close the opening of the fixed portion 141B on the outer side in the y direction, and is movable relative to the fixed portion 141B. The way the second shutter 142B moved is not limitative. In the illustrated example, the second shutter 142B moves up and downward in the z direction. The mechanism for moving the second shutter 142B (not shown) is not limitative and, for example, use may be made of an air cylinder or a motor.

The carry-out shutter 143B serves to open and close the opening of the fixed portion 141B on the inner side in the y direction, and is movable relative to the fixed portion 141B. The way the carry-out shutter 143B moves is not limitative. In the illustrated example, the carry-out shutter 143B moves up and downward in the z direction. The mechanism for moving the carry-out shutter 143B (not shown) is not limitative and, for example, use may be made of an air cylinder or a motor. The first cover 14A may further include a shutter similar to the carry-out shutter 143B. When the first cover 14A includes a shutter similar to the carry-out shutter 143B, for example, the first transport system 3 can utilize this shutter, as a carry-in port for carrying the substrate W into the first chamber 1A, without passing through the preparation stage 2, differing from this embodiment. In addition, forming the first cover 14A and the second cover 14B in the same configuration enables various usages of the substrate processing units U1, U2 as respective units. Further, when the substrate processing units U1, U2 previously utilized for a certain purpose are used for a different purpose, the number of parts that have to be modified can be reduced.

The shape of the second cover 14B is not limitative. In the illustrated example, the second cover 14B protrudes to the outer side in the y direction as viewed in the z direction, and includes, for example, a semicircular portion. Accordingly, the second shutter 142B also has an arcuate shape as viewed in the z direction. The carry-out shutter 143B has a flat plate shape.

In addition to the first chamber 1A and the second chamber 1B, each of the substrate processing units U1, U2 may further include another chamber or another processing tank for performing, for example, a swelling process, whereby the substrate W is sunk in the processing liquid stored in a container for a long time, thereby causing the resist layers and the like to swell and be dissolved. For example, the chamber or processing tank for performing the swelling process may be additionally provided for a preceding process of the process performed in the first chamber 1A. Alternatively, the first chamber 1A may be configured to perform the swelling process. A chemical solution containing a chemical agent is often employed as the processing liquid for the swelling process. Individually providing the chamber in which such chemical solution is used (e.g., the chamber or processing tank that executes the swelling process, and the first chamber 1A), and the second chamber 1B that performs water-washing using pure water as the processing liquid, enables the chemical solution and the pure water to be perfectly isolated from each other. Such a configuration prevents the chemical solution from being unintentionally diluted by the pure water, which is advantageous for reutilizing the chemical solution. In addition, the substrate processing units U1 and U2 may further include another chamber, posterior to the second chamber 1B, so that the substrate W is carried out of the substrate processing units U1 and U2 through the additional chamber.

The paired piping units 5 serve to circulate the processing liquid used for the first process in the first chamber 1A and the second process in the second chamber 1B. The number of piping units 5 provided for each substrate processing unit U1, U2 is not limitative, and use may may be made of a single piping unit or more than two piping units. In this embodiment, the substrate processing unit U1 and the substrate processing unit U2 each include a first piping unit 5 corresponding to the first chamber 1A, and a second piping unit 5 corresponding to the second chamber 1B.

The structure of each piping unit 5 is not limitative. The piping unit 5 includes, for example, a processing liquid tank to store the processing liquid, and a plurality of piping components such as valves, filters, pumps and the like.

The first transport system 3 serves to carry substrates W into the substrate processing units U1 and U2, and carry them out of the substrate processing units U1 and U2. In this embodiment, the first transport system 3 is located between the substrate processing unit U1 and the substrate processing unit U2 in the y direction. In other words, the first transport system 3 is located on the inner sides of the respective substrate processing units U1, U2 in the y direction.

The structure of the first transport system 3 is not limitative. For example, a robot such as a vertical multijoint robot, a horizontal multijoint robot, or a Cartesian robot may be employed for the first transport system 3. In the illustrated example, the first transport system 3 is a horizontal multijoint robot, and includes a holder 31, an arm 32, and a drive section 33.

The holder 31 serves to retain the substrate W. The arm 32 is configured in a horizontal multijoint form, so as to freely move the holder 31 to a desired position. The drive section 33 serves to drive the arm 32 and includes, for example, a servomotor. The drive section 33 is also configured to move the entirety of the first transport system 3 in the x direction. The drive section 33 may further be configured to move the holder 31 and the arm 32 up and downward in the z direction.

The two second transport systems 4A and 4B serve to transport the substrate W in the first chamber 1A and the second chamber 1B. Specifically, the second transport system 4A carries the substrate W out of the first chamber 1A, and into the second chamber 1B in the substrate processing unit U1. The second transport system 4B carries the substrate W out of the first chamber 1A, and into the second chamber 1B in the substrate processing unit U2.

In this embodiment, the two second transport systems 4A and 4B are opposed to each other in the y direction across the two substrate processing units U1 and U2. The second transport system 4A is located on the outer side (yl-side) in the y direction with respect to the substrate processing unit U1. The second transport system 4B is located on the outer side (y2-side) in the y direction with respect to the substrate processing unit U2.

The structure of the second transport systems 4A and 4B is not limitative. For example, a robot such as a vertical multijoint robot, a horizontal multijoint robot, or a Cartesian robot may be employed for the second transport systems 4A and 4B. The two second transport systems 4A and 4B may have the same configuration as each other, or different configurations. In this embodiment, the two second transport systems 4A and 4B have the same configuration as each other. In the illustrated example, each of the two second transport systems 4A and 4B is a Cartesian robot, and includes a holder 41, an arm 42, a rod 43, a drive section 44, a drive section 45, and a rail 49.

The holder 41 serves to retain the substrate W. The arm 42 supports the holder 41, and is elongate in the y direction. The drive section 44 is configured to cause the arm 42 to reciprocate in the y direction. The drive section 44 includes, for example, a motor. The rod 43 supports the drive section 44, and is elongate in the z direction. The drive section 45 serves to move the rod 43. The drive section 45 causes the rod 43 to reciprocate in the x direction, by running along the rail 49 in the x direction. The drive section 45 may also be configured to move the rod 43 up and downward in the z direction.

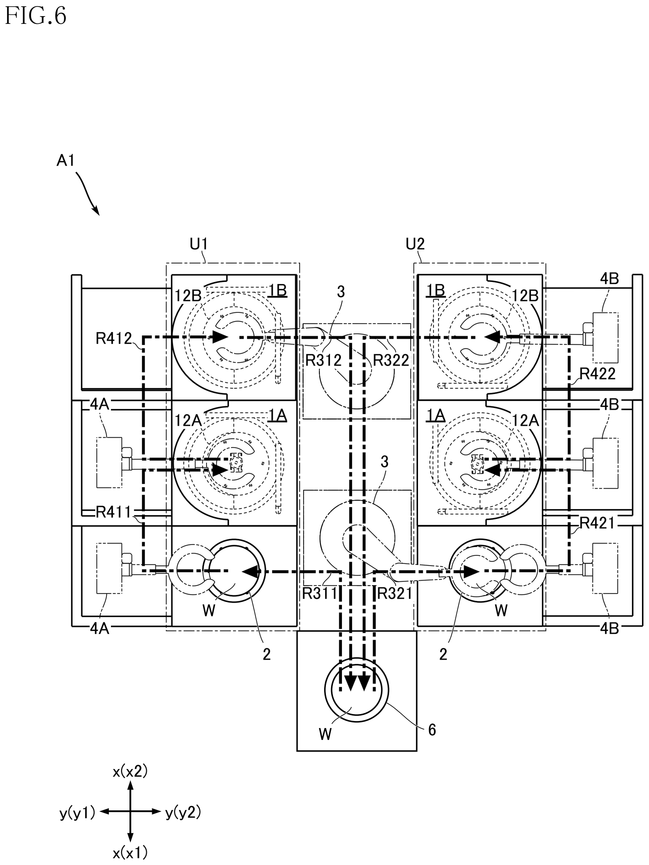

FIG. 6 illustrates an example of the transport route of the substrate W in the substrate processing apparatus A1. The substrate W placed on the load/unload stage 6 is transported by the first transport system 3 to the preparation stage 2 of the substrate processing unit U1 (route R311), or to the preparation stage 2 of the substrate processing unit U2 (route R321). The substrate W placed on the preparation stage 2 of the substrate processing unit U1 is carried by the second transport system 4A into the first chamber 1A (route R411). The substrate W which has undergone the first process in the first chamber 1A is carried by the second transport system 4A out of the first chamber 1A, and into the second chamber 1B (route R412). Then, the substrate W which has undergone the second process in the second chamber 1B is carried by the first transport system 3 out of the second chamber 1B, and placed on the load/unload stage 6 (route R312). On the other hand, the substrate W placed on the preparation stage 2 of the substrate processing unit U2 is carried by the second transport system 4B into the first chamber 1A (route R421). The substrate W which has undergone the first process in the first chamber 1A is carried by the second transport system 4B out of the first chamber 1A, and into the second chamber 1B (route R422). Then, the substrate W which has undergone the second process in the second chamber 1B is carried by the first transport system 3 out of the second chamber 1B, and placed on the load/unload stage 6 (route R322). Thus, in this embodiment, the first transport system 3 performs the transport along the routes R311, R312, R321, and R322, the second transport system 4A performs the transport along the routes R411 and R412, and the second transport system 4B performs the transport along the routes R421 and R422.

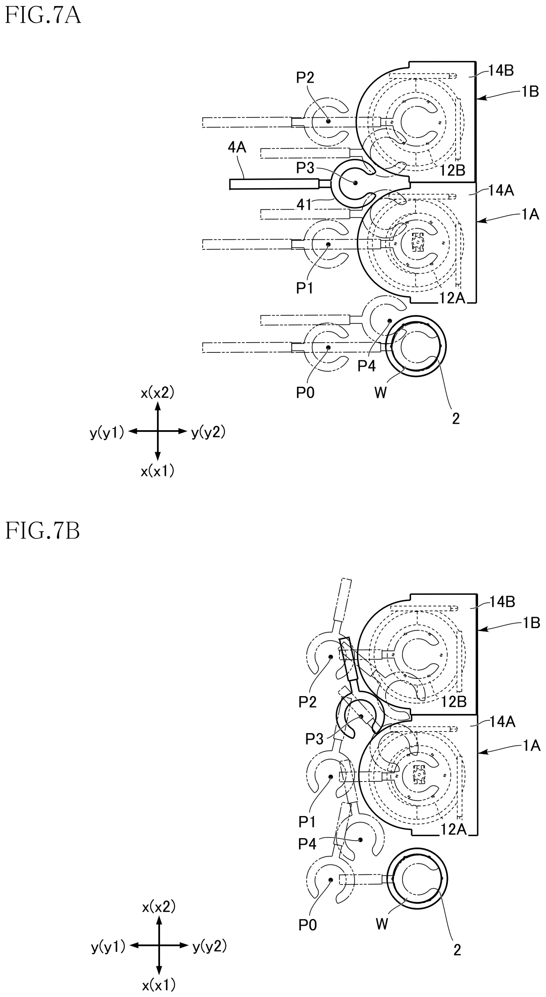

FIG. 7A illustrates an example of the transport performed by the second transport system 4A. The second transport system 4A can move the holder 31 so as to pass through positions P0, P1, P2, P3, and P4. The position P0 is located in front of the preparation stage 2 on the y1-side in the y direction. The position P1 is located in front of the first chamber 1A on the y1-side in the y direction, which is the position that does not interfere with the first cover 14A in the closed state. The position P2 is located in front of the second chamber 1B on the y1-side in the y direction, which is the position that does not interfere with the second cover 14B in the closed state. The positions P0, P1, and P2 may be the same in the y direction.

The position P3 is located outside of the first chamber 1A and the second chamber 1B, such that the holder 41 overlaps with the first chamber 1A and the second chamber 1B, as viewed in the x direction, and overlaps with the first chamber 1A and the second chamber 1B, as viewed in the y direction. In addition, the position P3 is where the holder 41 and the substrate W retained thereby do not interfere with the first cover 14A and the second cover 14B in the closed state. The position P3 corresponds to an intermediate standby position by the present invention.

The transport along the route R411 in FIG. 6 may pass through the position P0 and the position P1. Specifically, the transport along the route R411 may pass through the position P4 in FIG. 7A, instead of passing through the position P0 and the position P1. The transport along the route R412 in FIG. 6 may pass through the position P1 and the position P2. Specifically, the transport along the route R412 may pass through the position P3 in FIG. 7A, instead of passing through the position P1 and the position P2.

In the example shown in FIG. 7A, the second transport system 4A is a Cartesian robot. Thus, the holder 41 can be moved at least with two degrees of freedom, namely the reciprocating motion in the x direction and the reciprocating motion in the y direction.

In the example shown in FIG. 7B, the second transport system 4A has different degrees of freedom. The second transport system 4A can be moved at least with two degrees of freedom, namely the rotation about the axis extending in the z direction, and the reciprocating motion in the x direction. In this example, the second transport system 4A can also move the holder 31 so as to pass through the positions P0, P1, P2, P3, and P4.

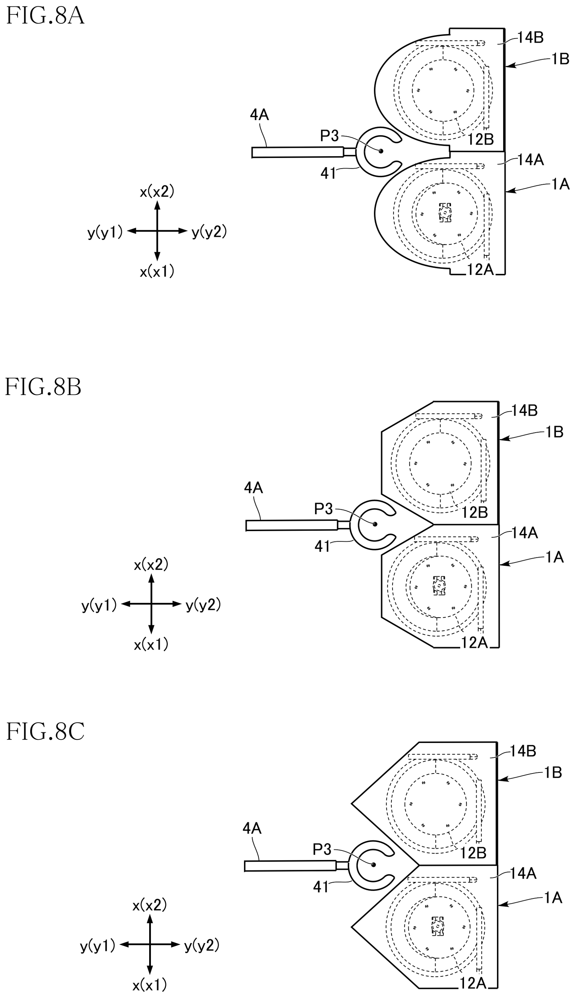

FIG. 8A to FIG. 8C illustrate other examples of shapes of the first cover 14A and the second cover 14B. In the example shown in FIG. 8A, the first cover 14A and the second cover 14B each include a portion of semielliptical shape. In the example shown in FIG. 8B, the first cover 14A and the second cover 14B each include a portion of trapezoidal shape. In the example shown in FIG. 8C, the first cover 14A and the second cover 14B each include a portion of triangular shape. In these examples, the second transport system 4A can move the holder 41 so as to pass through the position P3 corresponding to the intermediate standby position by the present invention.

The advantages of the substrate processing apparatus A1 will be described below.

According to the present embodiment, as shown in FIG. 6, the first transport system 3 transports a substrate W along the routes R311 and R312, and the second transport system 4A transports a substrate W along the routes R411 and R412. Accordingly, a substrate W can be transported along the route R311 or R312, and another substrate W along the route R411 or R412 at the same time in parallel. In other words, the transport of a substrate W along the route R311 or R312 and the transport of a substrate W along the route R411 or R412 do not need to wait for the transport along the other route to finish. This is advantageous to improving processing capacity of the substrate processing apparatus A1. In addition, since the first process in the first chamber 1A includes moistening the substrate W, the substrate W is wet during the transport along the route R412. On the other hand, the substrate W being transported along the route R311 is yet to be processed, and the substrate W being transported along the route R312 has undergone the process performed in the substrate processing unit U1. Thus, a substrate W which is likely to be wet is transported by the second transport system 4A, and the first transport system 3 only needs to transport a substrate W in the dry state. Such an arrangement prevents the first transport system 3, supposed to transport dry substrates W, from being unduly moistened, thereby enabling more appropriate transport of substrates.

The first chamber 1A and the second chamber 1B are aligned along the x direction, and the second transport system 4A and the first transport system 3 are opposed to each other in the y direction across the substrate processing unit U1. Therefore, the first transport system 3 and the second transport system 4A can be prevented from interfering with each other. This is also advantageous to preventing the first transport system 3 from being moistened.

In the substrate processing apparatus A1, the substrate processing unit U1 and the substrate processing unit U2 are located on the opposite sides of the first transport system 3, in the y direction. By using a single first transport system 3 to transport the substrate W with the two substrate processing units U1 and U2, it is possible to prevent the configuration of the apparatus from becoming complicated, and also to improve the processing capacity of the substrate processing apparatus A1. Further, the second transport systems 4A and 4B are located outside of the substrate processing units U1 and U2 in the y direction with an appropriate spacing between them. Therefore, the second transport systems 4A and 4B can be prevented from interfering with each other, which is advantageous to improving the processing capacity of the substrate processing apparatus A1.

As shown in FIG. 7A and FIG. 7B, the second transport system 4A can move the holder 31 so as to pass through the position P3. Accordingly, for example, the holder 31 retaining the substrate W carried out from the first chamber 1A can be located at the position P3, to stand by until the process on another substrate W in the second chamber 1B is finished. When the process in the second chamber 1B is finished, and the second shutter 142B is opened, the holder 31 located at the position P3 can be quickly moved to inside of the second cover 14B, so that the substrate W can be more quickly carried into the second chamber 1B. Such carrying-in can be performed more quickly than when the holder 31 is caused to stand by at the position P2. Thus, such an arrangement is more preferable for improving processing capacity of the substrate processing apparatus A1. In addition, the second process in the second chamber 1B can be more quickly performed after the first process in the first chamber 1A is finished. This is advantageous to preventing the quality of the substrate W from deteriorating due to residual chemical solution or other substance on the substrate W, whereby the finish quality of the processed substrate can improve.

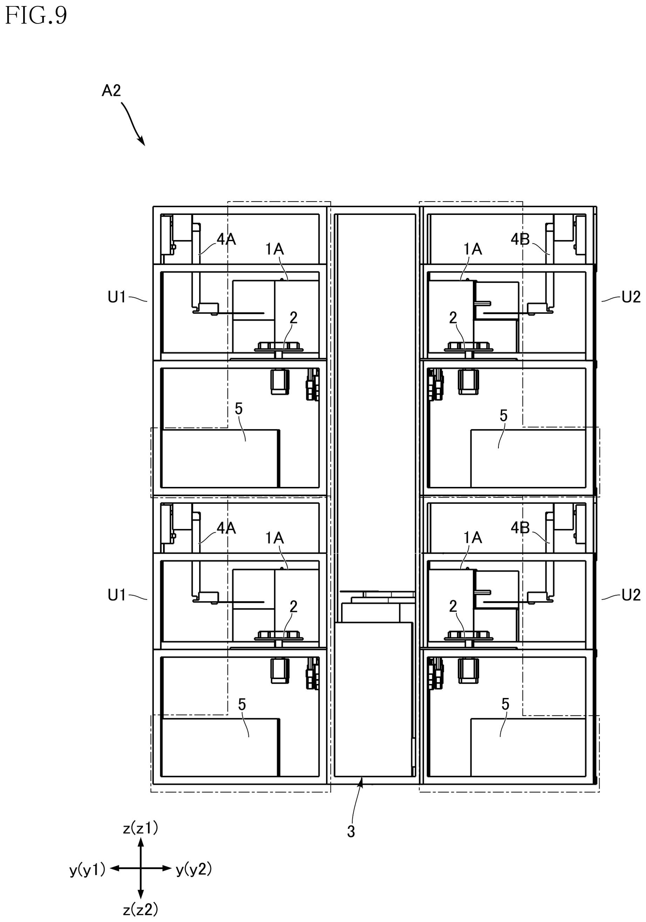

FIG. 9 to FIG. 14B illustrate other embodiments of the present invention. In these drawings, the elements same as or similar to those of the first embodiment are indicated by the same reference numerals. The configurations of the elements in the embodiments and variations may be combined as desired unless technical contradiction is incurred.

### <Second Embodiment>

FIG. 9 illustrates a substrate processing apparatus according to a second embodiment of the present invention. The substrate processing apparatus A2 of this embodiment includes two substrate processing units U1 and two substrate processing units U2. The substrate processing apparatus A2 includes two second transport systems 4A and two second transport systems 4B. Further, the substrate processing apparatus A2 includes at least one first transport system 3. In other words, the substrate processing apparatus A2 includes two substrate processing apparatuses, each configured similarly to the substrate processing apparatus A1, stacked positioned in the z direction, one above the other. The first transport system 3 may serve to perform the carrying-in and -out of the substrate W with respect to the two substrate processing units U1 and the two substrate processing units U2. Alternatively, the substrate processing apparatus A2 may include two first transport systems 3, provided at an upper position and a lower position in the z direction.

The configuration of this embodiment also improves the processing capacity of the substrate processing apparatus A2, and realizes more appropriate transport of substrates. Further, in this embodiment, the substrate processing units U1 and U2 are unitized based on a pre-considered design philosophy. Thus, the resulting substrate processing apparatus can be set up in a wider variety of forms, based on different combinations of substrate processing units U1, U2, first transport system(s) 3, and second transport systems 4A, 4B.

### <Third Embodiment>

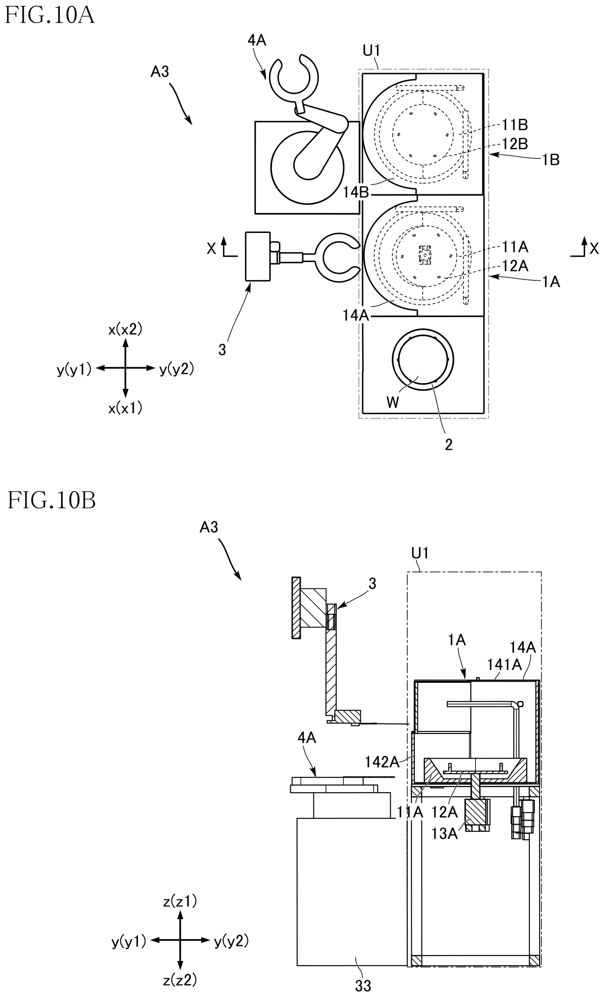

FIG. 10A and FIG. 10B illustrate a substrate processing apparatus according to a third embodiment of the present invention. The substrate processing apparatus A3 of this embodiment includes a substrate processing unit U1, a first transport system 3 and a second transport system 4A. The first transport system 3 and the second transport system 4A are located on the same side, namely the y1-side in the y direction with respect to the substrate processing unit U1.

The first transport system 3 of this embodiment is, for example, a Cartesian robot, and configured similarly to the second transport system 4A of the foregoing embodiments. The second transport system 4A of this embodiment is, for example, a horizontal multijoint robot, and configured similarly to the first transport system 3 of the foregoing embodiments. The first transport system 3 and the second transport system 4A are spaced apart from each other in the z direction, and can transport substrates W without interfering with each other.

The configuration of this embodiment also improves the processing capacity of the substrate processing apparatus A3, and realizes more appropriate transport of the substrates. Further, as seen from this embodiment, the substrate processing apparatus of the present invention may include a single substrate processing unit. In addition, the first transport system 3 and the second transport system 4A may be located on the same side of the substrate processing unit U1.

### <Example of Processing Liquid Tank 51>

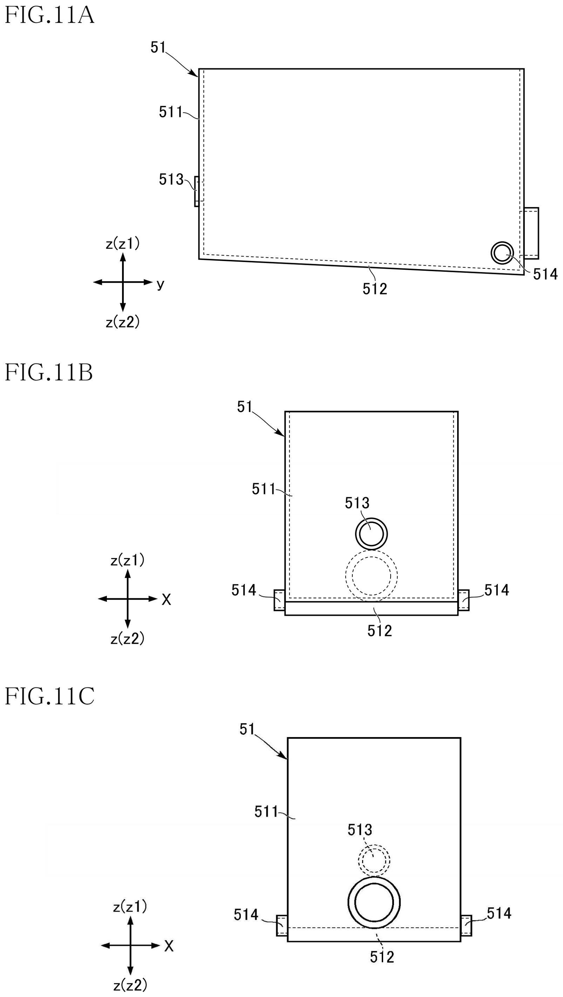

FIG. 11A, FIG. 11B, and FIG. 11C illustrate an example of the processing liquid tank 51 provided in the piping unit 5. The processing liquid tank 51 shown in these drawings includes a lateral face 511, a bottom face 512, a first outlet 513, and second outlets 514.

The lateral face 511 is erected in the z direction, and as viewed in the z direction, the lateral face 511 constitutes a closed rectangular frame. The bottom face 512 is connected to the z2-side of the lateral face 511 in the z direction, thereby closing the z2-side of the lateral face 511. The first outlet 513 is disposed on one side of the processing liquid tank 51 in the y direction. The first outlet 513 provides communication between the inside and outside of the processing liquid tank 51. The second outlets 514 are disposed on the opposite side of the processing liquid tank 51 in the y direction. The second outlets 514 provide communication between the inside and outside of the processing liquid tank 51. In the illustrated example, the first outlet 513 and the second outlets 514 are spaced apart in the y direction.

The first outlet 513 is located on the z1-side in the z direction with respect to the second outlets 514. In the illustrated example, the processing liquid tank 51 includes two second outlets 514. The two second outlets 514 are located on the opposite sides of the processing liquid tank 51 in the x direction. The number and locations of second outlets 514 are not limitative. For example, a single second outlet 514 may be provided on a central position in the x direction. It suffices that the first outlet 513 and the second outlet(s) 514 are located so as to cause impurities described below to accumulate near the second outlet(s) 514. Further, the bottom face 512 is inclined with respect to the y direction such that it has an upper portion close to the first outlet 513 and a lower portion that is close to the second outlet(s) 514 and disposed on the z2 side with respect to the upper portion in the z direction. according to the present disclosure, the bottom face 512 may be inclined as a whole with respect to the y direction, and may have a curved shape, a bent shape or a stepped shape other than a flat shape.

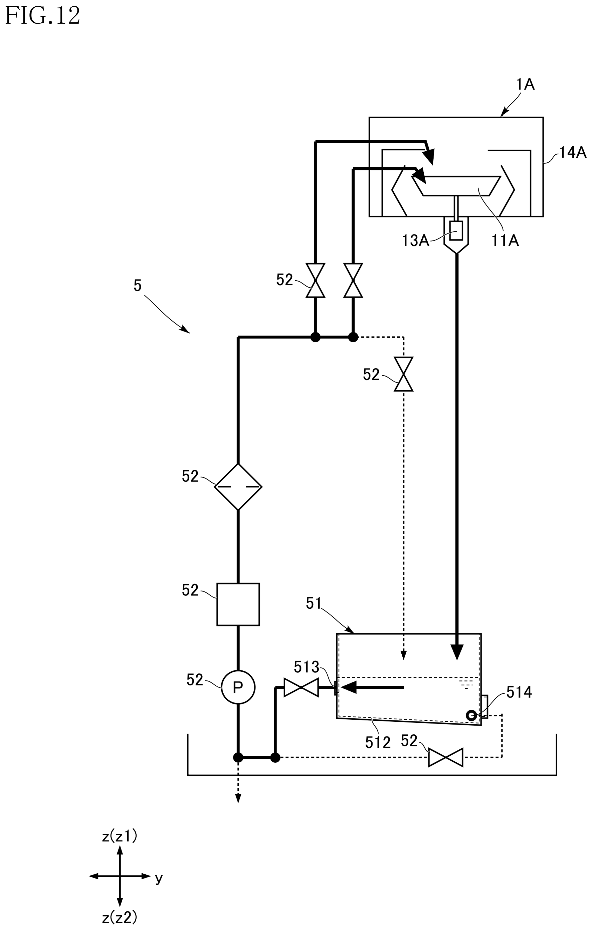

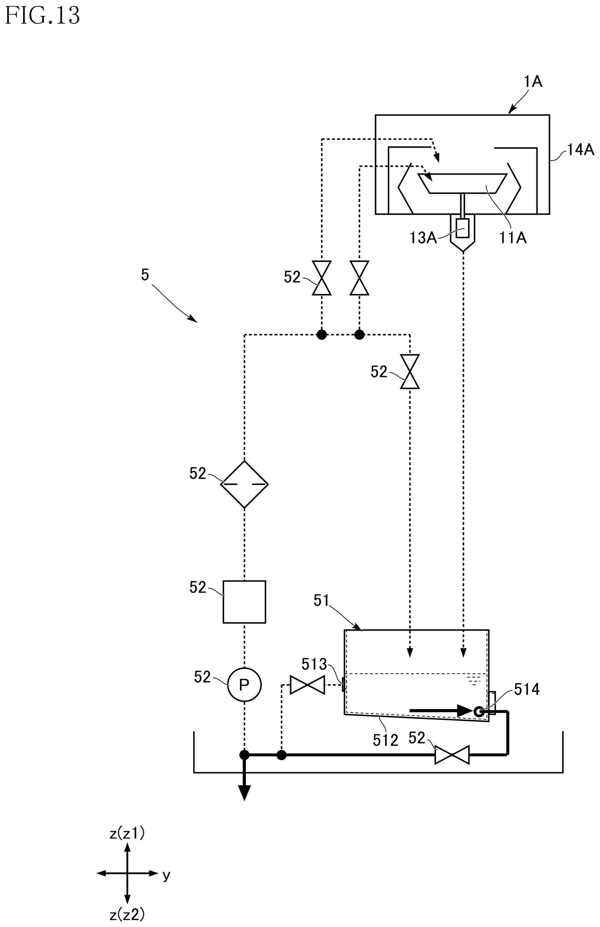

FIG. 12 and FIG. 13 illustrate a flow path of the processing liquid in the substrate processing apparatus including the processing liquid tank 51 shown in FIG. 11. The processing liquid stored in the first container 11A is supplied to the processing liquid tank 51. From the first outlet 513, the processing liquid stored in the processing liquid tank 51 can be discharged. The processing liquid stored in the processing liquid tank 51 can also be discharged from the second outlet(s) 514. The piping components 52 in the piping unit 5, such as valves, filters, pumps and the like, are provided for the circulation of the processing liquid.

In the flow path shown in FIG. 12, the piping components 52 connected to the first outlet 513, i.e., valves, are opened, while the piping component 52 connected to the second outlet(s) 514, i.e., a valve(s), is closed. When one of the piping components 52, i.e., the pump P is activated, the processing liquid stored in the processing liquid tank 51 is discharged from the first outlet 513 to be supplied to the first container 11A, whereas the processing liquid is not discharged from the second outlet 514. The processing liquid stored in the first container 11A flows into the processing liquid tank 51. Thus, the processing liquid circulates via the processing liquid tank 51 and the first container 11A.

In the flow path shown in FIG. 13, the piping components 52 connected to the first outlet 513, i.e., the valves, are closed, while the piping component 52 connected to the second outlet(s) 514, the valve(s), is opened. Accordingly, the processing liquid is discharged from the second outlet(s) 514 to outside of the piping unit 5, while the processing liquid is not discharged from the first outlet 513.

According to the present embodiment, the bottom face 512 is inclined with respect to the y direction as noted above. This is advantageous to facilitating the accumulation of the impurities such as peeled-off resist layers produced in the first process and the second process at locations close to the second outlet(s) 514 in the y direction. Accordingly, when the processing liquid is made to circulate along the flow path shown in FIG. 12, the impurities can be prevented from being unduly flown into the first container 11A. In addition, suppressing the impurities from circulating in the piping unit 5 contributes, for example, to the prevention of clogging of the filter(s) included in the piping components 52. Thus, the number of steps of maintenance work for the piping unit 5 can be reduced. When the processing liquid is drained from the piping unit 5, the processing liquid is discharged from the second outlet(s) 514. Accordingly, the impurities in the proximity of the second outlet(s) 514 can be discharged easily from the second outlet(s) 514 together with the processing liquid. Thus, the processing liquid to be used for the processing can be prevented from contamination, while the impurities can be smoothly discharged to outside of the substrate processing apparatus. Further, the first outlet 513 is located at one side of the processing liquid tank 51 in the y direction, and the second outlets 514 are located at the opposite side of the processing liquid tank 51 in the y direction. In other words, the first outlet 513 and the second outlet(s) 514 are spaced apart from each other by an advantageously long distance. Thus, it is possible to more reliably prevent the impurities accumulated in the proximity of the second outlet(s) 514 from being discharged via the first outlet 513.

### <Fourth Embodiment>

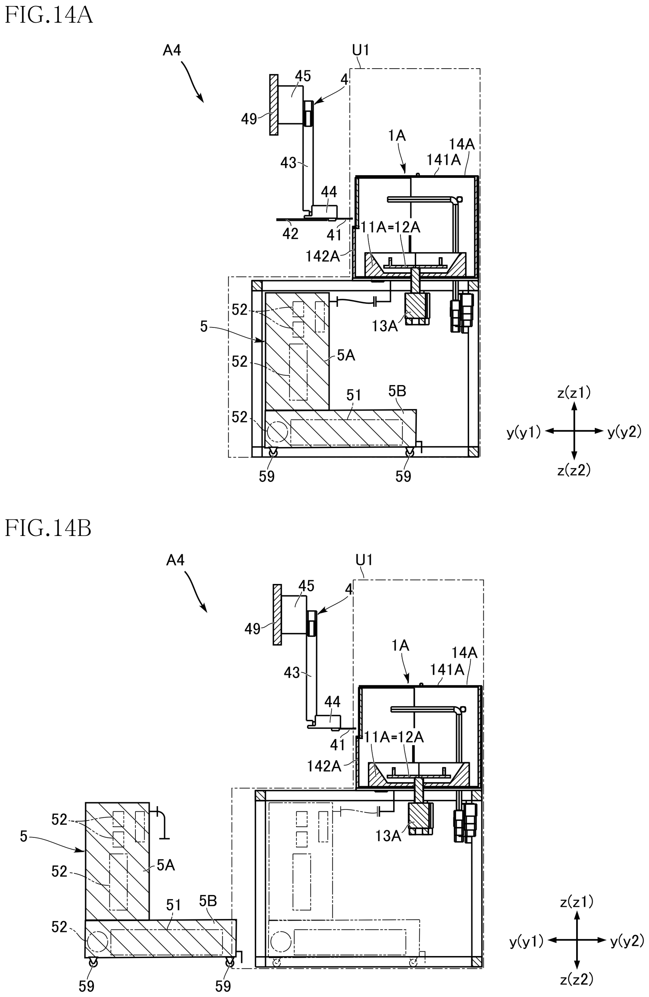

FIG. 14A and FIG. 14B illustrate a substrate processing apparatus according to a fourth embodiment of the present invention. The substrate processing apparatus A4 of this embodiment is different from the foregoing embodiments in the configuration of the piping unit 5. The piping unit 5 of this embodiment can be removed out from the substrate processing unit U1 with the first chamber 1A and the second chamber 1B being fixed in position. Specifically, the piping unit 5 can be moved to the y1-side in the y direction, thereby being pulled out from the substrate processing unit U1, while the first chamber 1A and the second chamber 1B remain fixed to the support framework.

The structure of the piping unit 5 is not limitative. In the illustrated example, the piping unit 5 includes a first portion 5A and a second portion 5B. The first portion 5A and the second portion 5B each include a plurality of piping components 52 as shown in FIG. 12 and FIG. 13. For example, the first portion 5A includes piping components 52 such as filters and valves. The second portion 5B includes piping components 52 such as pumps, and may also include a processing liquid tank 51. The processing liquid tank 51 is, for example, located right under the first chamber 1A, on the z2-side in the z direction. The first portion 5A is located on the z1-side in the z direction with respect to the second portion 5B, and located offset to the y1-side in the y direction with respect to the first chamber 1A. Further, as the illustrated example, the piping unit 5 may include a number of casters 59. The casters 59 are attached to the second portion 5B to facilitate the pull-out of the piping unit 5.

The piping unit 5 and the first container 11A of the first chamber 1A may be connected to each other via a quick coupling, for example. The quick coupling is fastened when the piping unit 5 operates in collaboration with the first chamber 1A. For pulling out the piping unit 5 from the substrate processing unit U1, the quick coupling may be unfastened in advance.

According to the present embodiment, the piping unit 5 can be removed when maintenance work for the piping unit 5 is to be performed, while the states of the first chamber 1A and the second chamber 1B do not need to be changed, as shown in FIG. 14B. For instance, if the first drive mechanism 13A and the second drive mechanism 13B need to be removed for performing the maintenance work of the piping unit 5, it should take a considerable time to perform the maintenance work for the piping unit 5. The configuration of the present embodiment contributes to significantly reducing the time required for the maintenance work of the piping unit 5.

The substrate processing apparatus according to the present invention is not limited to those of the foregoing embodiments, and the configurations of the respective elements of the substrate processing apparatus of the present invention may be modified in various ways.

## Claims

1. A substrate processing apparatus comprising:
a substrate processing unit including a first chamber that performs a first process including moistening a substrate, and a second chamber that performs a second process on the substrate after the first process;
a first transport system that brings the substrate into the substrate processing unit, and brings the substrate out of the substrate processing unit; and
a second transport system that brings the substrate out of the first chamber, and brings the substrate into the second chamber.

2. The substrate processing apparatus according to claim 1, wherein the first process employs a chemical solution containing a chemical agent as a processing liquid, and
the second process includes water-washing the substrate.

3. The substrate processing apparatus according to claim 1, wherein the first chamber and the second chamber are aligned in a first direction, and
the first transport system and the second transport system are opposed to each other across the substrate processing unit in a second direction perpendicular to the first direction.

4. The substrate processing apparatus according to claim 3, comprising:
the first transport system;
two of the substrate processing units opposed to each other across the first transport system in the second direction; and
two of the second transport systems opposed to each other across the two substrate processing units in the second direction.

5. The substrate processing apparatus according to claim 3 or 4, wherein the second transport system includes a holder that retains the substrate, and
the holder is configured to move via an intermediate standby position outside of the first chamber and the second chamber, the intermediate standby position overlapping with the first chamber and the second chamber as viewed in the first direction, the intermediate standby position overlapping with the first chamber and the second chamber as viewed in the second direction.

6. The substrate processing apparatus according to claim 5, wherein the first chamber includes a first cover,
the second chamber includes a second cover, and
each of the first cover and the second cover includes a portion that is opposed to the second transport system and has an arcuate shape as viewed in a third direction perpendicular to the first direction and the second direction.

7. The substrate processing apparatus according to claim 1, wherein the substrate processing unit further includes a chemical tank for storing a chemical solution for processing the substrate,
the chemical tank includes a first outlet and a second outlet for discharging the chemical solution, and a bottom face located at a lower position in a vertical direction,
the first outlet is located at an upper position from the second outlet in the vertical direction, and
the bottom face is inclined with respect to a direction in which the first outlet and the second outlet are spaced apart from each other in a manner such that a portion of the bottom face on a side of the second outlet is lower in the vertical direction.

8. The substrate processing apparatus according to claim 1, wherein the substrate processing unit further includes a piping unit through which a chemical solution for processing the substrate flows, and
the piping unit is configured to be removed out from the substrate processing unit with the first chamber and the second chamber remaining fixed.
